# EUROPEAN PATENT SPECIFICATION

(11) **EP 0 721 998 B1**
(45) Date of publication and mention of the grant of the patent: **13.01.1999**
(21) Application number: 96100465.2
(22) Date of filing: 03.08.1990
(51) Int. Cl.: C23C 16/26, C23C 16/50

(54) **Method for vapour deposition of diamond film**
Verfahren zur Diamantabscheidung mittels CVD
Procédé dépôt chimique en phase vapeur de diamant

(43) Date of publication of application: 17.07.1996
(62) Divisional of application: 90308570.2
(73) Proprietor: FUJITSU LIMITED, Kawasaki-shi, Kanagawa 211 (JP)
(72) Inventor: Kawarada, Motonobu, Sagamihara-shi, Kanagawa 228 (JP); Kurihara, Kazuaki, Atsugi-shi, Kanagawa 243-02 (JP); Sasaki, Ken-ichi, Atsugi-shi, Kanagawa 243-02 (JP); Teshima, Akimoto, Isehara-shi, Kanagawa 259-11 (JP); Koshino, Nagaaki, Yokohama-shi, Kanagawa 241 (JP)
(74) Representative: Overbury, Richard Douglas

(56) References cited:
- EP-A- 0 279 898
- US-A- 5 108 813
- PATENT ABSTRACTS OF JAPAN vol. 013, no. 402 (C-633), 6 September 1989 & JP-A-01 145314 (SUMITOMO ELECTRIC IND LTD), 7 June 1989,

## Description

The present invention relates to a method and apparatus for a vapor deposition of diamond film. More specifically, it relates a highly efficient method and apparatus for uniformly vapor depositing a diamond film having superior adhesiveness to a treated object or substrate, superior hardness, and smoothness and also for depositing a diamond film on a carburizing material.

Diamond is an allotrope of carbon (C), exhibits a diamond structure, has a high Mohs hardness of 10, and has a superior thermal conductivity of 1000 or 2000 W/mK, compared with other materials. Therefore, various applications have been developed using these characteristics.

For example, it has been considered to use it for drill blades or bites by utilizing its high hardness. Attempts have been made to cover such tools, which are made of high hardness sintered alloys such as tungsten carbide (WC), with a diamond film. Further, diamond is utilized as a heat sink of an LSI, VLSI, or laser diode or other semiconductor device using the high heat conductivity thereof.

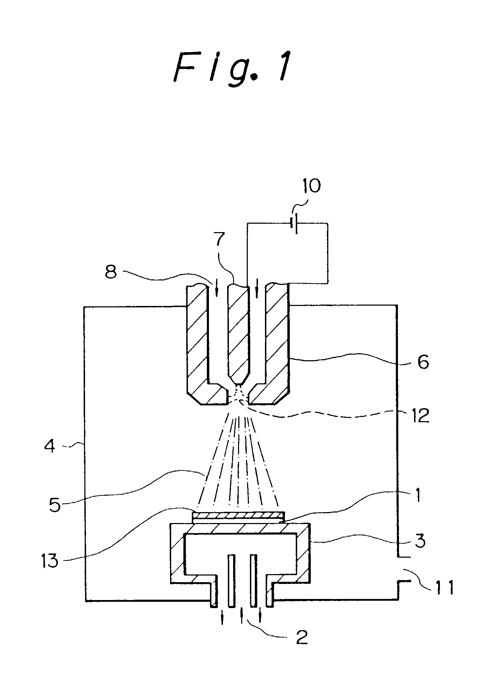

When coating a diamond film on a tool made of tungsten carbide (WC) or molybdenum carbide (MoC), even if a chemical vapor deposition apparatus (abbreviated as a "CVD" apparatus) is used similar to that as shown in Fig. 1 and the film is grown directly by chemical vapor deposition (abbreviated as "CVD"), the film easily peels off due to the difference in the coefficient of heat expansion.

The operation of the above-mentioned known apparatus is as follows.

An object (for example, a tool) to be treated or substrate is placed on a substrate holder 3 cooled by cooling water 2. At the top of the reaction chamber 4 is an anode 6 and a cathode 7 for forming a plasma jet 5. A starting gas 8 is supplied between the anode and the cathode. A DC power source 10 is provided connecting the anode 6 and the cathode 7. At the bottom of the reaction chamber 4 is an exhaust outlet 11. For the CVD growth of diamond, a mixed gas of hydrogen (H₂) and a hydrocarbon, for example, methane (CH₄) is supplied from between the anode 6 and cathode 7 to the inside of the reaction chamber 4. The exhaust system is operated for exhaust from the exhaust outlet 11 and the inside of the reaction chamber 4 is held at a low vacuum, in which state an arc discharge 12 is caused between the anode 6 and cathode 7, the heat of which causes decomposition and plasmatization of the starting gas 8, whereupon the plasma jet 5 including carbon plasma strikes the metal plate 1 and a diamond film 13 composed of fine crystals is grown on the metal plate 1. Thus, it becomes possible to grow a diamond film 13 on the treated object 1, but since the coefficients of heat expansion differ (for example, the linear expansion coefficient of diamond is 0.0132 x 10⁻⁴K⁻¹, while that of W is 0.045 x 10⁻⁴K⁻¹) and since the temperature is decreased from the high temperature of 800°C or more at which the CVD reaction is performed to ordinary temperature, the diamond film 13 easily peels off from the treated object 1.

Therefore, in the past prior art, when coating a diamond film on a tool made of WC, for example, elements (for example, Co) included in the WC as sintering reinforcements and causing a reduction of the adhesiveness were chemically removed, then the CVD method was used to grow the diamond film or mechanical scratches were made and the growth performed over the same. However, since the adhesiveness falls along with the film thickness, the limit of the thickness of the film grown was only several or some µm and even so the adhesiveness was insufficient for practical use. The inventors previously proposed, as a method for resolving this problem, the provision of a coating material layer 15 with a coefficient of heat expansion close to diamond on the treated object 1, as shown in Fig. 2, and the growth of a diamond film 13 on the same (Japanese Unexamined Patent Publication (Kokai) No. 1-145313 published June 7, 1989). However, when actually used, the adhesiveness provided is not still satisfactory for tool use.

As mentioned above, diamond has the highest hardness among all materials, so attempts have been made to use it to form drill blades and bits. However, when diamond is coated on a tool made of, for example, WC, it easily peels off since the heat expansion coefficients differ and therefore this has not been commercialized.

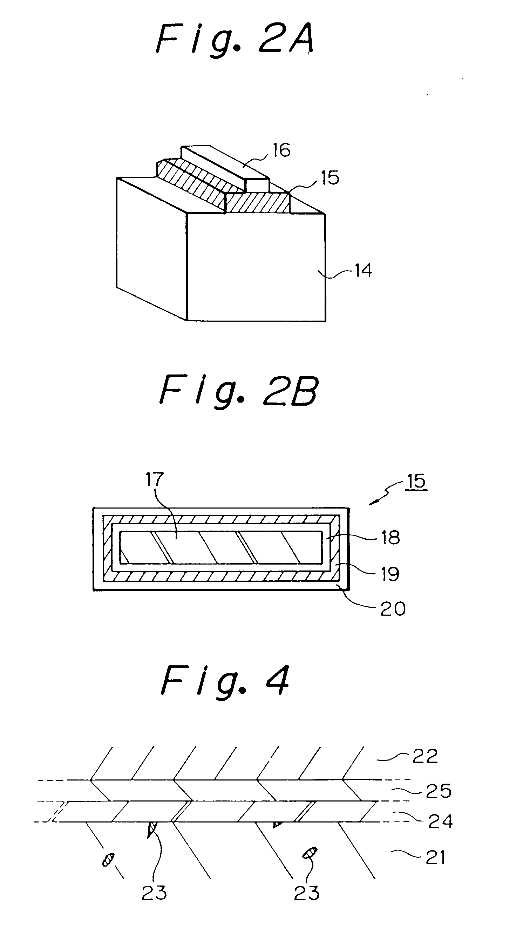

As mentioned earlier, since diamond shows a high heat conductivity, it has come under attention as a heat sink for semiconductor devices and is being commercialized for this. Figure 2A is a perspective view of a cooling structure, wherein a heat sink 15 comprised of diamond is brazed by gold on a subcarrier 14 comprised of copper (Cu). On top of this heat sink 15 is bonded a semiconductor laser or other semiconductor chip 16 by, for example, gold-tin solder.

Figure 2B shows the sectional structure of the heat sink 15, wherein a titanium (Ti) film 18, platinum (Pt) film 19, and gold (Au) film 20 are formed in successive layers on the same in thicknesses of about 2000 Å respectively. The reason why the Ti film 18 is used is that it forms titanium carbide (Tic) with the diamond film 17 and has a good adhesiveness. Further, the reason why the Pt film 19 is interposed is so as to correct the poor wettability of the Ti film 18 and Au film 20. However, such a heat sink 15 suffers from considerable effects of the heat conductivity of the metal films enclosing it when considered from the complicated nature of the structure. Further, the bonding action requires a high temperature, so the semiconductor chip can easily deteriorate, or the bonding requires a special skill, so the price becomes high.

According to this apparatus, when a plate 1 is plated on a substrate holder cooled by cooling water 2, it becomes possible to form the diamond film 13.

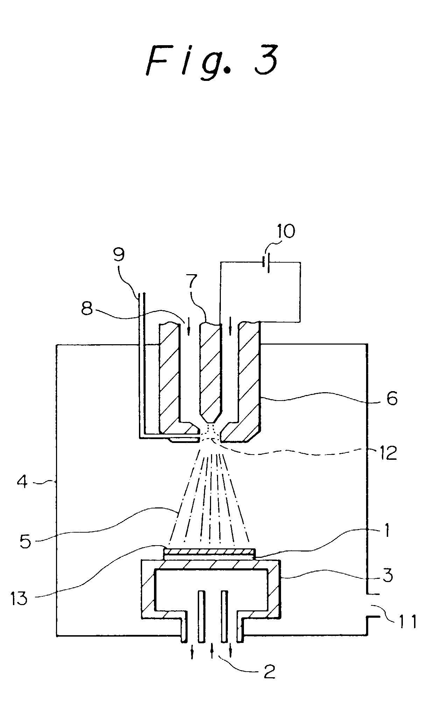

As mentioned above, diamond has an extremely superior heat conductivity of 2000 W/mK, so it is being commercialized as a component material for heat sinks, but as shown in Fig. 3, a Ti/Pt/Au and metal film are formed in layers on the diamond film. Therefore, there are the problems that the heat conductivity of the diamond is impaired and the cost becomes higher.

Furthermore, as mentioned above, diamond is used for high performance tools utilizing its hardness and is used as heat sinks for devices with large generation of heat such as laser diodes as it has a high heat conductivity of as much as several times that of copper. However, the surface of conventional thick diamond films has been very rough and use of these films has required polishing the surface with a diamond disk etc. This polishing work has required considerable time and labor. The density of nucleus production of diamond is 10⁷ to 10⁹ cm⁻² , remarkably smaller than with other materials (10¹³), therefore specific crystal particles selectively grow and the surface becomes very rough. In particular, this trend is striking with thick diamond films (about 0.2 mm with film thicknesses of 2 mm).

Furthermore, as mentioned above, attempts have been made to cover tools with diamond by utilizing its high hardness. As methods for synthesizing diamonds, there are known the high pressure synthesis method and low pressure synthesis method. The high pressure synthesis method is suitable for forming relatively large sized monocrystals, but the apparatus is cumbersome and the speed of growth is very slow, so there is the problem of a higher cost. As opposed to this, the low pressure synthesis method includes the microwave plasma chemical vapor deposition method and the electron assisted chemical vapor deposition method. The speed of growth is much higher compared with the former method and it is possible to form diamond as fine crystals on the treated substrate.

Contrary to the above, the present inventors developed chemical vapor deposition (CVD) of a diamond film using the plasma jet chemical vapor growth apparatus as shown in Fig. 1, as mentioned above. However, as the reason for growing the diamond film by plasma jet CVD, CH₄ and other hydrocarbons are heated rapidly to a high temperature in the arc discharge region and decompose to be ejected as a plasma jet which strikes the metal plate 1 to lose energy and crystallize as diamond. Not all the carbon (C) constituting the hydrocarbon turns into diamond at this time. A considerable amount of precipitates are formed as amorphous carbon or graphite on the metal plate 1, but hydrogen gas (H₂) mixed with the hydrocarbon as the starting gas 8 reduces the amorphous carbon or graphite nondiamond component to CH₄ , C₂H₆ and other hydrocarbons which are removed as a gas.

Actually, however, the removal action of the H₂ gas is not complete and such nondiamond components are detected in almost all diamond film formed by the plasma jet CVD method. This has been a factor for reducing the hardness.

As mentioned earlier, diamond has a high hardness of 10,000 kg/mm², so has been taken note of as a coating material for various tools, but the diamond film obtained by the plasma jet CVD method contains amorphous carbon or graphite, resulting in an insufficient hardness.

Furthermore, in the past, diamond has been used for high performance tools utilizing its hardness and used as heat sinks for devices with large generation of heat such as semiconductor lasers since it has a high heat conductivity of as much as several times that of copper.

However, when a diamond film is formed by CVD, since the material serving as the substrate is a material (a carburizing type, for example, Ni, Co, and Fe) through which carbon can be permeable, the component of carbon has dispersed in the substrate and made synthesis of a diamond film impossible. Therefore, when using a diamond film for a tool or heat sink in the prior art, it has been limited to base materials (the arm in the case of a tool and a subcarrier in the case of a heat sink) other than carburizing materials. However, it would be very convenient if it is possible to form a hard film like diamond on a soft material like a carburizing material.

EP-A-0 279 898 discloses a method of depositing a diamond film on a substrate, which uses CVD, chemical plasma deposition or reactive plasma sputtering to deposit a series of diamond-containing layers on a substrate, the diamond content of the layers being increased from the lowermost to the uppermost layer.

According to a first aspect of the present invention, there is provided a method of forming a diamond coating on a substrate comprising synthesizing a diamond film on the substrate by the CVD method using a gas of a material for forming the diamond and powders of an element for promoting the formation of diamond nuclei, wherein the diamond film is formed by a method comprising the steps of: effecting an arc discharge while feeding a discharge gas containing hydrogen and a carbon source between an anode and a cathode of a thermal plasma chemical vapor deposition device; radicalizing a gaseous carbon compound by feeding the gaseous compound to a generated plasma jet, in which the hydrogen molecules are substantially dissociated into hydrogen atoms while feeding a powder of an element for promoting the formation of the diamond nuclei; and permitting said radicalized plasma jet to impinge on the object to be treated, to thereby form a film of diamond on the object.

According to a second aspect of the present invention, there is provided a method of synthesis of a diamond film comprising the steps of: (i) forming a protective film on a substrate of a carburizing material by plasma injection using an element capable of easily forming a carbide with a high melting point; and, then (ii) forming a diamond film over the protective film by a plasma CVD method: wherein said protective film is formed by a method comprising, while effecting a plasma jet of an inert gas or hydrogen, feeding a powder of said element to the plasma jet; and wherein the diamond film is formed by a method comprising the steps of: effecting an arc discharge while feeding a discharge gas containing hydrogen and a carbon source between an anode and a cathode of a thermal plasma chemical vapor deposition device; radicalizing a gaseous carbon compound by feeding the gaseous compound to a generated plasma jet, in which the hydrogen molecules are substantially dissociated into hydrogen atoms; and permitting said radicalized plasma jet to impinge on the object to be treated, to thereby form a film of diamond on the object.

In an embodiment of the first aspect, the element for promoting the formation of diamond nuclei is at least one element selected from the group consisting of reducing metals, carburizing metals and metals capable of easily forming carbides and semiconductors capable of easily forming carbides. Preferably, the reducing metal is platinum. The carburizing metals may be any of nickel, cobalt, and iron, and the metals and semiconductors capable of easily forming carbides may be any of tungsten, silicon, titanium, and molybdenum.

In an embodiment of the second aspect, the element capable of easily forming a carbide is at least one element selected from the group consisting of silicon, molybdenum, titanium and tungsten.

The present invention also embraces a diamond film on a substrate formed by the method of the first aspect or second aspect.

For a better understanding of the invention and to show how the same may be carried into effect, reference will now be made by way of example only, to the accompanying drawings, in which:
Figure 1 illustrates the principle of the known apparatus for use in the formation of a diamond film on a substrate;
Fig. 2A is a perspective view of a cooling structure of the prior art;
Fig. 2B is a sectional view of a heat sink of the prior art;
Fig. 3 illustrates the principle of the present invention for use in the formation of a diamond film on an object or substrate;
Fig. 4 is a sectional view for explaining the present invention;
Fig. 5 is a sectional view of a heat sink using the present invention;
Fig. 6 is an X-ray diffraction pattern of a second intermediate layer;
Fig. 7 is a view of the Raman spectrum of Example 4;
Fig. 8 is a view of an X-ray diffraction pattern in the case of having the protective film of the present invention;
Fig. 9 is a view of an X-ray diffraction pattern in the case of not having the protective film;
Fig. 10 is an apparatus for coating a diamond film according to the present invention;
Fig. 11 is a cross-sectional view of the end portion of a substrate coated according to a prior art method; and
Fig. 12 is a cross-sectional view of the end portion of a substrate coated according to the present invention.

A method for raising the adhesiveness between the treated object and the diamond film, by using the CVD apparatus for forming the diamond film, two or more intermediate layers on the treated object, i.e., a first intermediate layer/second intermediate layer/diamond film (or a first intermediate layer/a second intermediate layer/a third intermediate layer/diamond film) are provided.

The operation of the present apparatus will now be briefly explained.

An object (for example, a tool) to be treated or substrate is placed on a substrate holder 3 cooled by cooling water 2. At the top of the reaction chamber 4 is an anode 6 and a cathode 7 for forming a plasma jet 5. A starting gas 8 is supplied between the anode and the cathode. To enable formation of a metal layer, a powder feed pipe 9 opens at the tip of the anode 6. A DC power source 10 is provided connecting the anode 6 and the cathode 7. At the bottom of the reaction chamber 4 is an exhaust outlet 11. For the CVD growth of diamond, a mixed gas of hydrogen (H₂) and a hydrocarbon, for example, methane (CH₄) is supplied from between the anode 6 and cathode 7 to the inside of the reaction chamber 4. The exhaust system is operated for exhaust from the exhaust outlet 11 and the inside of the reaction chamber 4 is held at a low vacuum, in which state an arc discharge 12 is caused between the anode 6 and cathode 7, the heat of which causes decomposition and plasmatization of the starting gas 8, whereupon the plasma jet 5 including carbon plasma strikes the metal plate 1 and a diamond film 13 composed of fine crystals is grown on the metal plate 1. According to the present invention to grow a mixed film of metal and diamond, a metal powder is supplied through the powder feed pipe 9 into the arc discharge 12, and to grow just a metal film, H₂ is used as the starting gas 8 and metal powder or inorganic material powder (e.g., silicon) is supplied through the powder feed pipe 9 into the arc discharge 12.

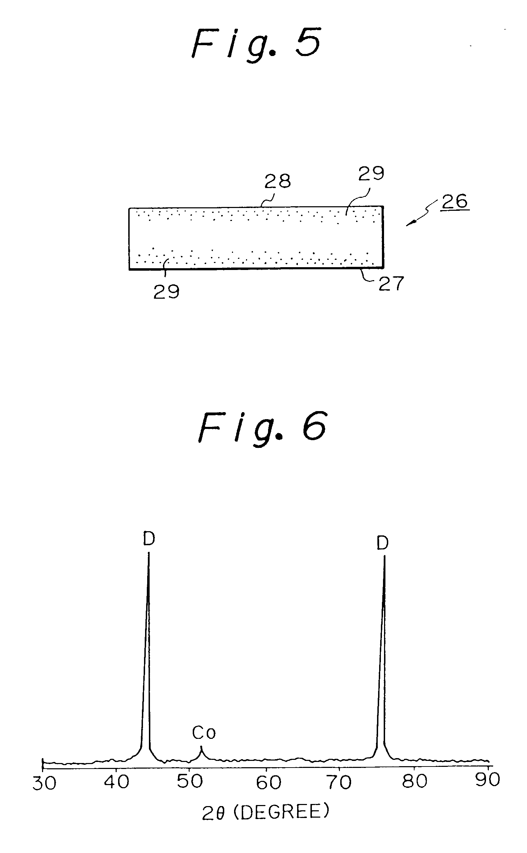

Figure 4 is a sectional view for explaining the present invention. In Fig. 4, the treated object 21 is a sintered body comprising WC or Mo₂C, in which sintered body is dispersed a sintering reinforcement 23 such as cobalt (Co). The present invention has a first intermediate layer 24 composed of a mixture of the main component material (e.g., 99.9 - 90 wt%) of the treated object 1, i.e., WC or MoC, and the component elements of the diamond sintering reinforcement agent (e.g., 0.1 - 10 wt%), i.e., cobalt (Co), iron (Fe), nickel (Ni), and other transition metals. The second intermediate layer 25 is composed of a mixture of the component elements (e.g., 0.1 - 10 wt%) of the diamond sintering reinforcement agent, i.e., cobalt (Co), iron (Fe), nickel (Ni), and other transition metals and diamond (e.g., 99.9 - 90 wt%). The diamond film 22 is grown on the second intermediate layer 25.

Furthermore, according to a preferred embodiment of the present invention, the three intermediate layers of (i) a first intermediate layer composed of (a) a component element (e.g., 99.9 - 90 wt%) of the object and (b) a component element (e.g., 0.1 - 10 wt%) of a sintering reinforcement agent for diamond, (ii) a second intermediate layer composed of a mixture of the materials of the first intermediate layer and (c) diamond (e.g., (b): 0.1 - 10 wt%, (a) + (c): 99.9 - 90 wt%, (a)/(c) = 10/90 - 90/10), and (iii) a third intermediate layer composed of (b) a component element (e.g., 0.1 - 10 wt%) of the sintering reinforcement agent and (c) diamond (e.g., 99.9 - 90 wt%).

The present invention, by providing at least two intermediate layers in this way, and gradually changing the composition of the treated object 21 and the diamond film 22, forms a diamond film 22 free from peeling even when formed to a thickness of about 100 µm.

Although there are no critical limitations to the thickness of the intermediate layers and the diamond film, the preferable thickness of each intermediate layer is 2 to 10 µm, more preferably 4 to 8 µm and the preferable thickness of the diamond film is 10 to 100 µm, more preferably 20 to 40 µm. Furthermore, the size of the powder is preferably 0.1 to 8 µm, more preferably 0.4 to 1 µm.

In an embodiment of the present invention, the surface, bottom, or entirety of a diamond film formed by the plasma jet chemical vapor deposition method is formed by a mixed phase comprised of component elements of metal bonding with said diamond film.

The present invention uses the above-mentioned CVD apparatus to form a mixed phase of diamond and a bonding metal element on the surface, bottom, or entirety of the diamond film.

Figure 5 is a sectional structural view of a diamond film in the case of use as a heat sink of a semiconductor device, wherein a mixed phase 29 of diamond and Cu is formed on the bottom surface 27 of the diamond film 26 which contacts a subcarrier 14 made of Cu and a top surface 28 contacting the semiconductor chip 16 in, for example, Fig. 2A.

Further, for mechanical applications utilizing the hardness of diamond, it is possible to form the mixed phase only on the bottom surface bonding with the object or form the entire film as the mixed phase.

The reason is that the diamond film formed by the CVD method is polycrystalline and therefore the shearing easily occurs at the crystalline interface and the crystal is relatively brittle, but since metal is interposed at the mixed phase, the mechanical strength is superior.

That is, when the diamond film is used as a heat conductor, the mixed phase may be just the bonded portion. Alternatively, for applications using hardness, the entire film may he formed by the mixed phase to eliminate the shearing.

In another embodiment of the present invention, a flat or plain diamond film is formed on a substrate by the CVD method using a starting gas (e.g., H₂, methane) for forming the diamond and a gas of an element for promoting formation of nuclei of the diamond such as reducing metals (e.g., Pt), carburizing metals (e.g., Ni, Co, Fe), or metals or semiconductors capable of easily forming carbides (e.g., W, Si, Mo, Ti).

In the present invention, a diamond coating is formed by simultaneously spraying or alternately spraying the above diamond forming a starting gas and diamond nucleus promoting element gas on the substrate by the CVD method or constantly spraying the starting gas and intermittently spraying the nucleus promoting element gas. That is, the method of the present invention, in the synthesis of diamond by the vapor phase synthesis method, sprays an element for promoting the formation of nuclei of diamond so as to generate large quantities of high density nuclei at the same time as the synthesis of the diamond film and thus suppresses the growth of specific crystal particles and gives a smooth or plain diamond film. Thus, the present invention tries to form a diamond coating using the above material gas by CVD.

In a further embodiment of the present invention, a diamond film having the desired high hardness can be formed on a substrate by exhausting a reaction chamber to vacuum by an exhaust system and while doing so supplying a mixed gas of a hydrocarbon gas and hydrogen gas between an anode and cathode provided in said reaction chamber, causing generation of a plasma jet of carbon by arc discharge, and forming a diamond film on the substrate, at which time adding a powder of an element of any one of tungsten (W), molybdenum (Mo), silicon (Si), or titanium (Ti), which can bond with the non-diamond carbon component in said plasma jet to form hard carbides.

The present invention uses the plasma jet CVD apparatus shown in Fig. 3 to form a diamond film. At that time, powder of, for example, W, Mo, Si, Ti, capable of forming hard carbides is added from a powder feed pipe and reacted with the amorphous carbon, graphite, and other nondiamond components to form hard carbides such as tungsten carbide (WC, hardness of 2200 kg/mm²), molybdenum carbide (Mo₂C, hardness of 1800 kg/mm²), silicon carbide (SiC, hardness of 2300 kg/mm²), titanium carbide (TiC, hardness of 3000 kg/mm²), and the like.

That is, the carbon of, for example, the amorphous carbon, graphite is more active energywise compared with diamond, so selectively bonds with radicals of metal elements in the plasma state and form hard carbides.

Thus, the present invention grows a diamond film by the plasma jet CVD method using a mixed gas of a hydrocarbon such as CH₄ and H₂ gas as a material gas and at that time changes the small amount of nondiamond components existing in the diamond polycrystalline layer due to the insufficient reduction and removal action of the H₂ gas to a hard carbide and thus improves the hardness.

In a further embodiment of the present invention, a diamond film is formed on a substrate made of a carburizing material by forming a protective film on a substrate of a carburizing material by plasma injection using an element easily forming a carbide with a high melting point and then forming a diamond film over the protective film by plasma CVD.

That is, the present invention enables, in the synthesis of diamond by the vapor phase synthesis method, the coating of a diamond film on a carburizing base material by providing a coating film facilitating the synthesis of diamond on the surface of the base material.

Examples of the carburizing material usable in the present invention, are Fe, Ni, Co, and other metals. Further, as the element easily forming a carbide with a high melting point, use is preferably made of WC, Si, Mo, W, or other elements. It is possible to use these materials and to work the method of the present invention using the same apparatus, as clear from the later mentioned examples.

When forming a protective film in the method of the present invention, hydrogen, argon, helium, or other inert gases are introduced in the apparatus and converted to plasma by DC arc discharge. The element easily forming carbides with a high melting point introduced from another pipe is melted by the high temperature generated at that time and forms a protective film over the substrate.

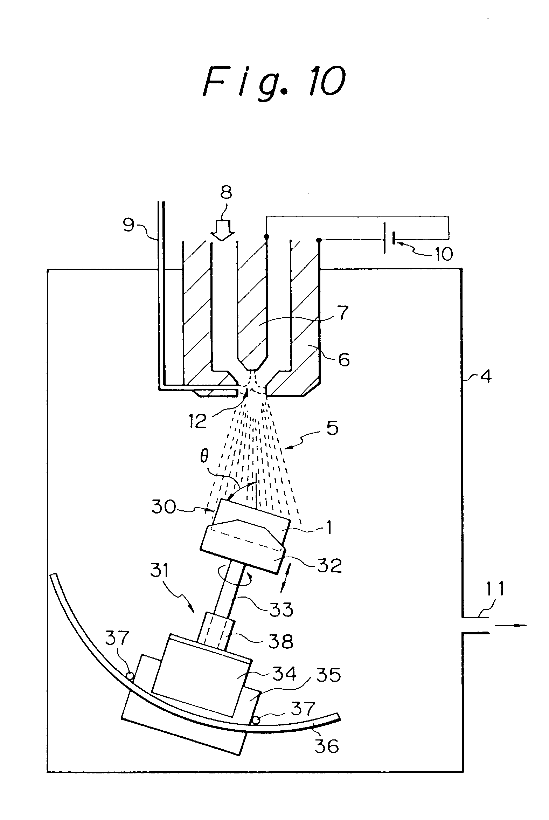

In a further embodiment of the present invention, a diamond film is uniformly and firmly deposited on an object or substrate even on the side surfaces thereof as shown in Figs. 10 to 12.

That is, when the above-mentioned intermediate layers and diamond films are to be formed on the object (or substrate) 1, the desired layers and diamond film are not deposited on the side faces 30 of the object, because the plasma jet 5 does not sufficiently impinge on the side surfaces 30 of the object 1. However, according to this embodiment, during the formation of the intermediate layers and the diamond film, the object 1 is rotated and is inclined from the flow direction line of the plasma jet 5 by 30 to 60 degree (see θ in Fig. 10), whereby the intermediate layers and the diamond film are uniformly and firmly deposited on the side faces 30 of the object 1.

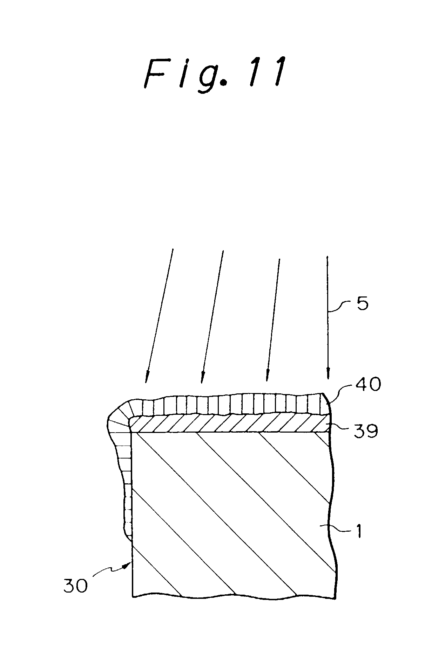

According to, for example, one embodiment of the present invention, if the intermediate layer 39 and the diamond film 40 are deposited on the side surfaces 30 of the object 1, the side surfaces 30 are not well covered by the intermediate layers 39, because the plasma jet 5 does not arrive at the side surfaces 30. Accordingly, the diamond film 40 is sometimes directly deposited on the side surfaces 39 as shown in Fig. 11. Thus, the diamond film 40 on the side surfaces 30 tends to be easily peeled off or cracks sometimes occur between the intermediate layer 30 and the diamond film 40 especially at the end portions of the object 1.

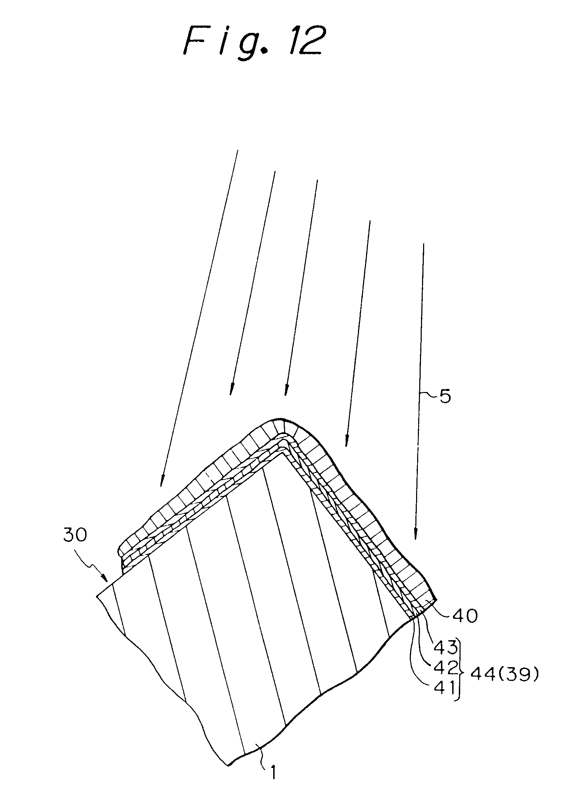

Contrary to the above, since the object 1 is rotated with an angle θ from the flow direction of the plasma jet 5 according to this embodiment, the side faces 30 of the object 1 can be uniformly and firmly covered with the intermediate layers 44 (39) and the diamond film 40, as shown in Fig. 12. In Fig. 12, a first intermediate layer 41 having a thickness of, for example, 2 - 5 µm is formed by introducing a powder of, for example, WC (the same material as the object), from a pipe 9 to a plasma jet 5 formed from hydrogen gas or an inert gas, a second intermediate layer 42 having a thickness of, for example, 10 - 20 µm is formed by introducing a powder of WC and a powder of, for example, Fe, Co, Ni, Nb and/or Ta, from a pipe 9 to the plasma jet 5 generated from hydrogen gas and a carbon source, and a third intermediate layer 43 having a thickness of, for example, 20 - 30 µm is formed by introducing a powder of, for example, Fe, Co, Ni, Nb and/or Ta (the same metal used in the formation of the second intermediate layer 42) from a pipe to a plasma jet 5, generated from hydrogen gas and a carbon source (e.g., hydrocarbon gas such as methane). Thereafter, a diamond film 40 having a thickness of, for example, 30 - 50 µm is formed in the same manner as mentioned above.

The inclination and rotation of the object (or substrate) 1 can be effected in any conventional manner. For example, as shown in Fig. 10, the supporting means 31 of the object (or substrate) 1 is composed of a cooled support 32 for the object 1, a motor 34 provided with a rotating shaft 33 for rotating the support 32, a movable base 35 for carrying the motor 34, and an arc-shaped guide member 36 for moving the movable base 35 so that the surface, to be coated, of the object 1 is inclined at an angle of θ. Although, in the above embodiment, the object 1 is moved so that it is inclined from the plasma jet flow direction, the plasma torch can also be moved in the similar manner.

### EXAMPLE

The present invention will now be explained, in detail, by, but by no means limited to, the following Examples.

### Example 1

As the treated object 1, a sintered body using Co as a sintering reinforcement and having a composition of WC-10% Co was used. As the component material of the first intermediate layer 24, WC and Co were used. Further, as the component material of the second intermediate layer 25, diamond and Co were used. As the conditions for growth of the second intermediate layer and diamond film, the CVD apparatus shown in Fig. 3 was used and H₂ gas of 10 to 50 liter/min and CH₄ gas of 0.05 to 1 liter/min were supplied. Further, an arc current of 10 to 70 A and an arc voltage changed in a range of 50 to 150 V were used. The vacuum of the reaction chamber was held in the range of 1 to 10 kPa.

When growing the first intermediate layer on the treated object, H₂ gas was supplied as the starting gas and a plasma jet generated, in which state WC and Co of a particle size of 1 to 5 µm were supplied from the powder feed pipe 9 at a rate of 0.01 to 0.1 cc/h and plasmatized to grow a mixture at a thickness of 20 µm.

The material gas was changed to a mixed gas of H₂ and CH₄ and Co powder of a particle size of 1 to 5 µm was supplied from the powder feed pipe 9 to create a plasma jet and form a second intermediate layer comprised of a mixture of diamond and Co at a thickness of 30 µm.

Figure 6 is an X-ray diffraction pattern of the second intermediate layer, where the diffraction lines of diamond (abbreviated as D) and Co appear well, so it is understood that a mixed layer is grown. Then, a plasma jet is created using a mixed gas of H₂ and CH₄ as a material gas and a diamond film of a thickness of about 100 µm is formed on the top. The adhesiveness with the treated object of the diamond film formed in this way is strong. A tensile test gave a value of more than 600 kg/mm².

### Example 2

The CVD apparatus shown in Fig. 3 was used and a starting gas 8 composed of hydrogen (H₂) gas changed in flow from 10 to 50 liter/min and methane gas (CH₄) changed in flow from 0.05 to 1 liter/min was supplied. Further, metallic powder comprised of Cu powder with a particle size of 1 to 5 µm was supplied using a powder feed pipe 9 at a rate of 0.01 to 0.1 cc/h.

When use is made of CH₄ gas and H₂ gas as the starting gas 8, a diamond film 13 is formed and when metal particulates are mixed in, a mixed phase of diamond and metal is formed. Further, when H₂ gas and a metal powder were used, a metal film is formed. Then, the conditions for causing CVD growth are a vacuum of the reaction chamber 4 of 1 kPa to 10 kPa, an arc current of 10 to 70 A, and an arc voltage of 50 to 150 V. Thus, there was formed a diamond film of a thickness of 50 µm having a mixed phase of Cu of a thickness of 1 µm with a ratio of composition of the top surface and bottom surface of about 5:1. Then, using this diamond film as a heat sink and using solder with a melting point of 250°C to bond this with the subcarrier or bond a laser diode on top of it, it was possible to solder with a sufficient bonding strength.

### Example 3

In an apparatus shown in Fig. 3, hydrogen gas, methane gas, or other starting gas 8 is introduced from the top of the plasma torch in the reaction chamber and made into plasma by DC arc discharge. That plasma 5 reacts on the substrate 1 to form a diamond film 13. In the process of synthesis, metal particulates may be introduced along with the material gas and metal vapor sprayed on the diamond surface. In the working of the present invention, 10 to 50 liter/min of hydrogen gas, 0.05 to 1 liter/min of methane gas, and a substrate of WC of a thickness of 0.5 mm and a surface area of 10 x 10 mm² were used. As the spraying powder material, 0.001 to 0.0001 cc of 1 to 5 µm particulates of W is supplied each time the thickness of the diamond film increases 0.1 mm. The arc current is 10 to 70 A and the arc discharge is 50 to 150 V. Further, the degree of vacuum of the reaction chamber is 1 k to 10 kPa. As a result, even with a diamond film of a thickness of 2 mm, the surface roughness is less than 0.05 mm.

Diamond films were synthesized under the same synthesis conditions but with different types of metal particulates and the surface roughness was measured. The results are shown in Table 1.

**Table 1**

| | Pt | W | Mo |
|---|---|---|---|
| Particle size (µm) | 1 - 2 | 0.45 - 1.0 | 0.7 - 1.0 |
| Arc discharge (A) | 10 - 40 | 30 - 70 | 30 - 70 |
| Diamond film roughness | 0.3 mm or less | 0.05 mm or less | 0.05 mm or less |

### Example 4

The CVD apparatus shown in Fig. 3 was used and a superhard alloy of W including 8% Co as the metal plate 1. As the conditions for supply of starting gas 8, the flow of hydrogen (H₂) gas was changed between a range of 10 to 50 liter/min and the flow of methane (CH₄) gas a range of 0.05 to 1 liter/min and, as a metal powder, a powder of W of 1 to 5 µm particle size was supplied at a rate of 0.01 to 0.1 cc/h. Then, the conditions where CVD were possible were a vacuum of the reaction chamber 4 of 1 kPa to 10 kPa, an arc current of 10 to 70 A, and an arc voltage of 50 to 150 V.

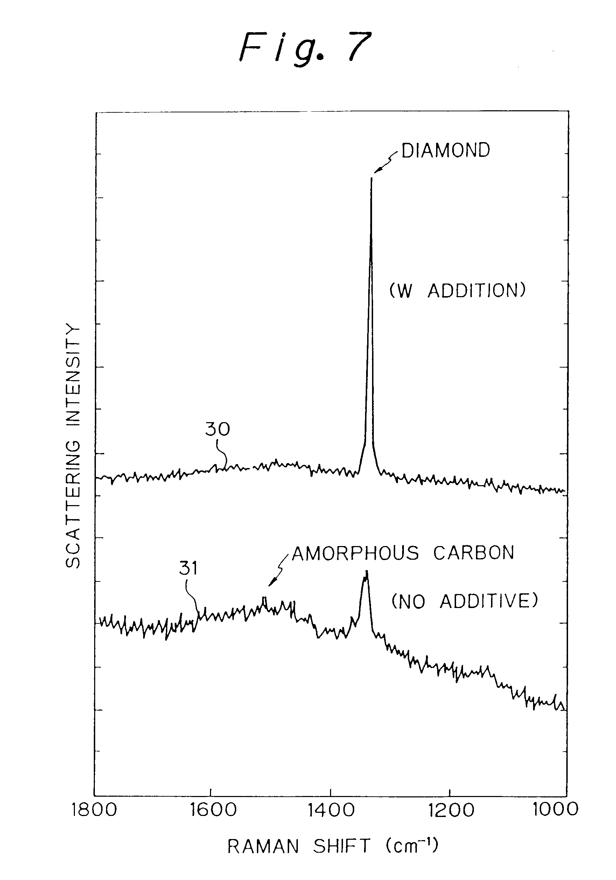

Figure 7 shows the Raman spectrum 30 of the film obtained by supplying W as the additive and the Raman spectrum 31 of the film with no additive. As will be understood from Fig. 7, a broad peak of amorphous carbon was observed near 1500 cm⁻¹ in the spectrum of the film with no additive.

On the other hand, it was possible to observe the sharp peak of diamond of 1333 cm⁻¹ at the spectrum 30 of the film obtained by supplying W, and the peak of the amorphous carbon near 1500 cm⁻¹ was extremely low.

It was confirmed from the Raman scattering that the diamond film synthesized in this way had an extremely small content of nondiamond components.

Further, the hardness of the diamond film formed in this way is about 10,000 kg/mm², close to that of natural diamond.

Note that even when the Mo, Si, or Ti metal powder is supplied from the powder feed pipe 9 to form the carbide, the conditions of formation of the diamond film are the same and it is possible to obtain a diamond film with hardness similar to the case of formation of WC.

In an apparatus shown in Fig. 3, use was made of a substrate 1 of Ni of a thickness of 0.5 mm and an inert gas (or hydrogen) was introduced into the plasma torch in the reaction chamber 4 at a flow rate of 10 to 50 liter/min. Then, using an arc current of 10 to 70 A and an arc voltage of 50 to 150 V, the inert gas was subjected to arc discharge and converted to plasma. Note that the vacuum in the reaction chamber was 1 k to 10 kPa.

At the same time as this plasmatization of the inert gas, WC particulates of 1 to 5 µm were supplied from a powder feed apparatus at a rate of 0.01 to 0.1 cc/h. The WC particulates were melted by the high temperature plasma and together with the plasma jet 5 deposited on the substrate 1 to form the protective film.

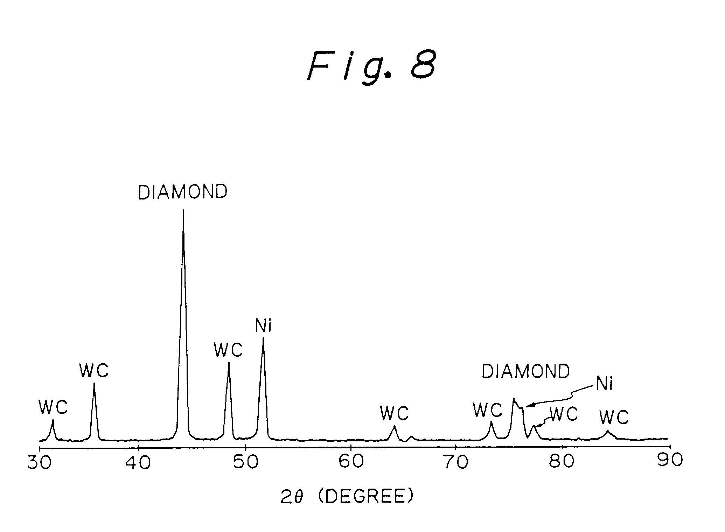

Then, the supply of the powder from the powder feed pipe 9 was stopped and starting gas for forming the diamond (methane or hydrogen) was introduced into the reaction chamber 4. The flow rates of feed of the methane gas and hydrogen gas were respectively 0.05 to 1 liter/min and 10 liter/min to 100 liter/min. The starting gas was converted to plasma by the DC arc discharge 12 at the same time and the plasma jet 5 deposited on the protective film to form the diamond film 13. The diamond film obtained by the method of the present invention was subjected to X-ray analysis and the pattern found. The pattern was shown in Fig. 8. As clear from the pattern, there were simultaneously a pattern of a protective film and a pattern of diamond and it was observed a diamond film was definitely synthesized.

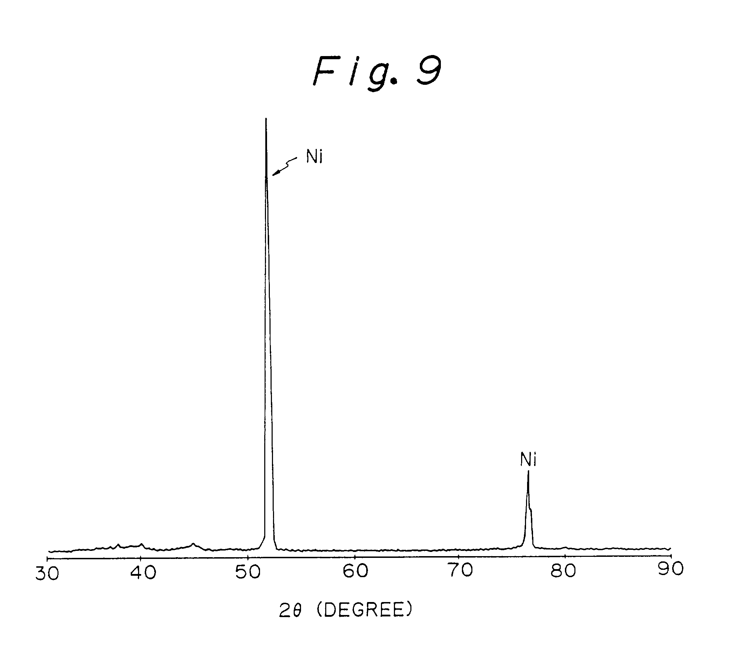

On the other hand, X ray analysis was performed on a substrate without a protective film. Its pattern is shown in Fig. 9. As clear from this Fig. 9, only the pattern of the substrate (Ni) was observed and no pattern of diamond was observed, so it was confirmed that no diamond film was synthesized.

According to the present invention, a diamond film having superior adhesiveness can be coated on a treated object, so it is possible to provide a diamond tool with a high reliability.

According to the present invention, by using a CVD apparatus which can form a mixed phase of a diamond film and metal by CVD growth changing the combination of the type of starting gas and metal powder and working the present invention wherein the surface, bottom, or entirety of the diamond film is made by the mixed phase, it is possible to obtain a diamond film superior adhesiveness at a low cost.

Furthermore, the method of the present invention, as explained above, uses a gas of a predetermined material to form a diamond film by the CVD method, so there is the effect that it is possible to considerably improve the smoothness of the surface of thick diamond film, reduce working costs, and raise work efficiency.

According to the present invention, it is easy to synthesize a diamond film with little amorphous carbon, graphite, or other nondiamond components and, by working the invention, to provide diamond tools at low cost.

As explained above, the present invention is further constituted so as to form a protective film of a predetermined material on a substrate and then synthesize a diamond film, so exhibits the effect of enabling coating of a diamond film on a carburizing base material, which was previously impossible.

## Claims

1. A method of forming a diamond coating on a substrate comprising synthesizing a diamond film on the substrate by the CVD method using a gas of a material for forming the diamond and powders of an element for promoting the formation of diamond nuclei, wherein the diamond film is formed by a method comprising the steps of:
effecting an arc discharge while feeding a discharge gas containing hydrogen and a carbon source between an anode and a cathode of a thermal plasma chemical vapor deposition device;
radicalizing a gaseous carbon compound by feeding the gaseous compound to a generated plasma jet, in which the hydrogen molecules are substantially dissociated into hydrogen atoms while feeding a powder of an element for promoting the formation of the diamond nuclei; and
permitting said radicalized plasma jet to impinge on the object to be treated, to thereby form a film of diamond on the object.

2. A method as claimed in claim 1, wherein said element for promoting the formation of diamond nuclei is at least one element selected from the group consisting of reducing metals, carburizing metals and metals capable of easily forming carbides and semiconductors capable of easily forming carbides.

3. A method as claimed in claim 2, wherein said reducing metal is platinum.

4. A method as claimed in claim 2 or 3, wherein said carburizing metals are nickel, cobalt, and iron.

5. A method as claimed in claim 2, 3, or 4, wherein said metals and semiconductors capable of easily forming carbides are tungsten, silicon, titanium, and molybdenum.

6. A method of synthesis of a diamond film comprising the steps of:
(i) forming a protective film on a substrate of a carburizing material by plasma injection using an element capable of easily forming a carbide with a high melting point; and, then
(ii) forming a diamond film over the protective film by a plasma CVD method:
wherein said protective film is formed by a method comprising, while effecting a plasma jet of an inert gas or hydrogen, feeding a powder of said element to the plasma jet;
and wherein the diamond film is formed by a method comprising the steps of:
effecting an arc discharge while feeding a discharge gas containing hydrogen and a carbon source between an anode and a cathode of a thermal plasma chemical vapor deposition device;
radicalizing a gaseous carbon compound by feeding the gaseous compound to a generated plasma jet, in which the hydrogen molecules are substantially dissociated into hydrogen atoms; and
permitting said radicalized plasma jet to impinge on the object to be treated, to thereby form a film of diamond on the object.

7. A method as claimed in claim 6, wherein said element capable of easily forming a carbide is at least one element selected from the group consisting of silicon, molybdenum, titanium and tungsten.

8. A diamond film on a substrate, obtained by the method according to any one of claims 1 to 7.

## Patentansprüche

1. Verfahren zur Bildung einer Diamantbeschichtung auf einem Substrat, welches das Synthetisieren eines Diamantfilms auf dem Substrat durch das CVD-Verfahren unter Verwendung von einem Gas eines Materials zur Bildung von Diamant und Pulvern eines Elements zur Förderung der Bildung von Diamantnuklei umfaßt, wobei der Diamantfilm durch ein Verfahren gebildet wird, das die Schritte umfaßt:
Bewirken einer Bogenentladung, während ein Wasserstoff und eine Kohlenstoffquelle enthaltendes Entladungsgas zwischen einer Anode und einer Kathode einer thermischen Plasma/chemischen Dampfabscheidungsvorrichtung zugeführt wird;
Radikalisieren einer gasförmigen Kohlenstoffverbindung, indem die gasförmige Verbindung einem erzeugten Plasmastrahl zugeführt wird, worin die Wasserstoffmoleküle im wesentlichen in Wasserstoffatome dissoziiert werden, während ein Pulver eines Elements zur Förderung der Bildung von Diamantnuklei zugeführt wird; und
Auftreffenlassen des radikalisierten Plasmastrahls auf dem zu behandelnden Objekt, um dadurch einen Diamantfilm auf dem Objekt zu bilden.

2. Verfahren nach Anspruch 1, bei welchem das Element zur Förderung der Bildung von Diamantnuklei zumindest ein Element ist, das aus der Gruppe bestehend aus Reduktionsmetallen, Carburierungsmetallen und Metallen, die leicht Carbide bilden können, sowie Halbleitern, die leicht Carbide bilden können, ausgewählt wird.

3. Verfahren nach Anspruch 2, bei welchem das Reduktionsmetall Platin ist.

4. Verfahren nach Anspruch 2 oder 3, bei welchem die Carburierungsmetalle Nickel, Cobalt und Eisen sind.

5. Verfahren nach Anspruch 2, 3 oder 4, bei welchem die Metalle und Halbleiter, die leicht Carbide bilden können, Wolfram, Silicium, Titan und Molybdän sind.

6. Verfahren zur Synthese eines Diamantfilms, welches die Schritte umfaßt:
(i) Bilden eines Schutzfilms auf einem Substrat eines Carburierungsmaterials durch Plasmainjektion unter Verwendung eines Elements, das leicht ein Carbid mit einem hohen Schmelzpunkt bilden kann; und dann
(ii) Bilden eines Diamantfilms über dem Schutzfilm durch ein Plasma-CVD-Verfahren:
wobei der Schutzfilm durch ein Verfahren gebildet wird, das, während ein Plasmastrahl aus einem Inertgas oder Wasserstoff erzeugt wird, das Zuführen eines Pulvers des Elements in den Plasmastrahl umfaßt;
und wobei der Diamantfilm durch ein Verfahren gebildet wird, das die Schritte umfaßt:
Bewirken einer Bogenentladung, während ein Wasserstoff und eine Kohlenstoffquelle enthaltendes Entladungsgas zwischen einer Anode und einer Kathode einer thermischen Plasma/chemischen Dampfabscheidungsvorrichtung zugeführt wird;
Radikalisieren einer gasförmigen Kohlenstoffverbindung, indem die gasförmige Verbindung einem erzeugten Plasmastrahl zugeführt wird, worin die Wasserstoffmoleküle im wesentlichen in Wasserstoffatome dissoziiert werden; und
Auftreffenlassen des radikalisierten Plasmastrahls auf dem zu behandelnden Objekt, um dadurch einen Diamantfilm auf dem Objekt zu bilden.

7. Verfahren nach Anspruch 6, bei welchem das Element, das leicht ein Carbid bilden kann, zumindest ein Element ist, das aus der Gruppe bestehend aus Silicium, Molybdän, Titan und Wolfram ausgewählt wird.

8. Diamantfilm auf einem Substrat, welcher durch das Verfahren nach einem der Ansprüche 1 bis 7 erhalten wird.

## Revendications

1. Procédé de formation d'un revêtement de diamant sur un substrat, comprenant la synthèse d'un film de diamant sur le substrat par un procédé de dépôt chimique en phase vapeur à l'aide d'un gaz d'une matière destinée à former le diamant et de poudres d'un élément destiné à favoriser la formation de germes de diamant, dans lequel le film de diamant est formé par un procédé qui comprend les étapes suivantes :
l'exécution d'une décharge disruptive avec transmission d'un gaz de décharge contenant de l'hydrogène et d'une source de carbone entre une anode et une cathode d'un dispositif de dépôt chimique en phase vapeur dans un plasma thermique,
la transformation radicalaire d'un composé gazeux du carbone par transmission du composé gazeux à un jet de plasma dans lequel les molécules d'hydrogène sont pratiquement dissociées en atomes d'hydrogène avec transmission d'une poudre d'un élément destiné à favoriser la formation des germes de diamant, et
la disposition du jet radicalaire de plasma afin qu'il puisse frapper l'objet à traiter avec formation de cette manière d'un film de diamant sur l'objet.

2. Procédé selon la revendication 1, dans lequel l'élément destiné à favoriser la formation des germes de diamant est au moins un élément choisi dans le groupe constitué par des métaux réducteurs, des métaux de carburation et des métaux qui peuvent facilement former des carbures et des semi-conducteurs capables de former facilement des carbures.

3. Procédé selon la revendication 2, dans lequel le métal réducteur est le platine.

4. Procédé selon la revendication 2 ou 3, dans lequel les métaux de carburation sont le nickel, le cobalt et le fer.

5. Procédé selon la revendication 2, 3 ou 4, dans lequel les métaux ou semi-conducteurs qui peuvent former facilement des carbures sont le tungstène, le silicium, le titane et le molybdène.

6. Procédé de synthèse d'un film de diamant, comprenant les étapes suivantes :
(i) la formation d'un film protecteur sur un substrat d'un matériau de carburation par injection d'un plasma à l'aide d'un élément capable de former facilement un carbure ayant une température élevée de fusion, puis
(ii) la formation d'un film de diamant sur le film protecteur par un procédé de dépôt chimique en phase vapeur en présence d'un plasma,
dans lequel le film protecteur est formé par un procédé qui comprend, lors de la formation d'un jet de plasma d'un gaz inerte ou d'hydrogène, l'introduction d'une poudre de l'élément dans le jet de plasma, et
dans lequel le film de diamant est formé par un procédé qui comprend les étapes suivantes :
la formation d'une décharge disruptive avec transmission d'un gaz de décharge contenant de l'hydrogène et d'une source de carbone entre une anode et une cathode d'un dispositif de dépôt chimique en phase vapeur en présence d'un plasma thermique,
la mise d'un composé gazeux du carbone sous forme radicalaire par transmission du composé gazeux à un jet de plasma dans lequel les molécules d'hydrogène se dissocient pratiquement en atomes d'hydrogène, et
la disposition du jet de plasma sous forme radicalaire afin qu'il puisse frapper l'objet à traiter, avec formation de cette manière d'un film de diamant sur l'objet.

7. Procédé selon la revendication 6, dans lequel l'élément capable de former facilement un carbure est au moins un élément choisi dans le groupe constitué par le silicium, le molybdène, le titane et le tungstène.

8. Film de diamant formé sur un substrat, obtenu par le procédé selon l'une quelconque des revendications 1 à 7.
